(19)

Europäisches
Patentamt
European
Patent Office
Office européen
des brevets

(11) **EP 4 653 901 A1**

(12) **EUROPEAN PATENT APPLICATION**

(43) Date of publication:
**26.11.2025 Bulletin 2025/48**

(21) Application number: **24177668.1**

(22) Date of filing: **23.05.2024**

(51) International Patent Classification (IPC):
***G01R 33/09*** (2006.01)        ***G01R 33/12*** (2006.01)
***H01F 10/00*** (2006.01)

(52) Cooperative Patent Classification (CPC):
**G01R 33/1284; G01R 33/093; G01R 33/098;
H01F 10/3254; H01F 10/329;** B82Y 25/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Centre National de la Recherche Scientifique
75016 Paris (FR)**
• **Université de Strasbourg
67000 Strasbourg (FR)**

(72) Inventors:
• **BAILLEUL, Matthieu
67800 Bischheim (FR)**
• **STOEFFLER, Daniel
67870 Griesheim (FR)**
• **ROSSI, Quentin
67800 Bischheim (FR)**

(74) Representative: **IPAZ
Bâtiment Platon
Parc Les Algorithmes
91190 Saint-Aubin (FR)**

(54) **SPIN WAVE DETECTION DEVICE AND METHOD USING MAGNETORESISTANCE EFFECTS**

(57)      The invention relates to a device (1) for the detection of spin waves, comprising
- a magnetic film (2) adapted to guide a spin wave excited by an excitation means (5),
- a magneto-resistive element (3),

wherein the magneto-resistive element (3) is coupled to the magnetic film (2) by magnetic coupling,
wherein the magneto-resistive element (3) is configured to exhibit a magneto-resistive effect in response to a magnetization state of the magnetic film (2), the magnetization state of at least a part of the magneto-resistive element (3) varying as a function of the guided spin wave, the device (1) further comprising:
- measurement means (6) configured to detect an electrical signal corresponding to the magneto-resistive effect.

The invention also relates to a method for the detection of spin waves.

Fig. 1

EP 4 653 901 A1

## Description

### Field of the invention

The present invention relates to a device and a method for the detection of spin waves.

The field of the invention is the field of spintronics, and more specifically the field of magnonics.

### Background

Information processing and storage devices in microelectronics consume energy. Spin electronics, or spin transport electronics (spintronics) and nano-magnetism make it possible to develop alternatives to traditional microelectronics semiconductor devices, taking advantage of the non-volatile nature of magnetism.

Among these alternatives, magnonics (spin-wave technologies) is a particularly promising technology, since it also offers possibilities specific to wave phenomena (interference and superposition phenomena).

Further developments in magnonics face a major obstacle which is the smallness of the signals associated with spin waves, in particular when converting them into the electrical domain as required for integration within a microelectronic architecture.

A first method known in the prior art is magneto-optical detection, which allows for image acquisition but produces relatively weak signals due to the smallness of the magneto-optical coefficients involved.

A second known technique is based on measuring a microwave signal induced in an adjacent conductor (called "antenna" in relation with spin waves). The signal being proportional to the involved total magnetic moment, and therefore to the volume of the device, this technique is not adapted to the nanometric scale which is relevant for modern microelectronics.

Information processing architectures using spin waves (or magnons) are considered to be particularly promising alternatives to traditional semiconductor devices. To date, in these magnonics devices, the "reading" of the information is done inductively, by measuring the induced voltage at electrodes acting as spin-wave antennas.

If this technique is reasonably efficient at the centimetre scale [1], its miniaturization leads to extremely small signals, given that the inductive voltages are proportional to the magnetic moment involved and therefore to the volume of the device.

Thus, existing sub-micrometric spin-wave antennas typically generate signals of the order of $\mu$V, which is too weak for the applications envisaged [2]. Applications include signal processing (tunable, non-reciprocal and/or non-linear smart delay lines) and non-conventional logic devices, incl. for example neural networks.

To extract an electrical signal of a sufficient level (in the order of 10 mV) from a propagating spin wave at the micrometric scale, it was first proposed to design semiconductor circuits for an on-chip amplification and detection [3]. However, the implementation of on-chip detection is bulky and energy-intensive (for example, surfaces in the order of 1 mm$^2$ and power in the order of some tens of mW).

It was also proposed to carry out electrical detection at the terminals of a bilayer presenting a spintronic effect called inverse Spin Hall Effect [4]. However, this solution of direct spintronic detection is little effective, with signals at the noise limit. This drawback is due to the compromise that has to be made in the choice of materials, since material systems exhibiting strong spin-to-charge conversion efficiencies mostly have very poor properties for spin-wave propagation. Furthermore, the integration of these effects involves very delicate technological steps (mastery of interfaces and etching stops at the atomic scale).

### Summary of the invention

A purpose of the present invention is to overcome at least one of the drawbacks of the known techniques.

A purpose of the present invention is to propose a spin-wave detection device that may be miniaturized while allowing for the measurement of exploitable electrical signals.

Another purpose of the present invention is to propose a device and a method for the detection of spin waves based on electrical signals with a good signal-to-noise ratio.

At least one of these aims is achieved by a device for the detection of spin waves, comprising

- a magnetic film adapted to guide a spin wave excited by an excitation means,
- a magneto-resistive element,

wherein the magneto-resistive element is coupled to the magnetic film by magnetic coupling,
wherein the magneto-resistive element is configured to exhibit a magneto-resistive effect in response to a magnetization state of the magnetic film, the magnetization state of at least a part of the magneto-resistive element varying as a function of the guided spin wave,
the device further comprising:

- measurement means configured to detect an electrical signal corresponding to the magneto-resistive effect.

The device according to the present invention allows for efficiently detecting spin waves thanks to the measurement of an electrical signal generated by the spin waves in the magnetically coupled assembly of magnetic materials. The association of two functionally dissociated magnetic materials - magnetic film as a spin-wave guide and magneto-resistive element as a magneto-resistive effect detector - allows for a convenient and polyvalent implementation of the device.

In the present document, the term "spin-wave detection" may refer to the measurement of spin waves, electrical signal transduction from spin waves, or interconversion involving spin waves.

According to an embodiment, the magnetic coupling may be one of dipolar coupling, direct magnetic exchange coupling, and indirect magnetic exchange coupling.

According to an embodiment, the magneto-resistive element may comprise a magneto-resistive stack comprising a first ferromagnetic layer, a second ferromagnetic layer, and a non-magnetic spacer layer between the first and second ferromagnetic layers, the magneto-resistive stack being configured to exhibit a giant magneto-resistance (GMR) effect or a tunnel magneto-resistive (TMR) effect.

The GMR effect corresponds to a variation of the electrical resistance of a magneto-resistive element as a function of the relative orientation of the magnetization directions of adjacent ferromagnetic layers. The resistance is low for parallel alignment and high for antiparallel alignment.

The TMR effect occurs in magnetic tunnel junctions consisting of two ferromagnetic layers separated by a thin insulating layer allowing for tunnelling of electrons. If the magnetization directions are parallel in the two ferromagnetic layers, it is more probable that electrons tunnel through the insulating film than if they are antiparallel. These two states correspond to two different values of the electrical resistance of the magnetic tunnel junction.

According to examples of a magneto-resistive stack, the first ferromagnetic layer may comprise iron, cobalt, nickel, or alloys of these materials, including a nickel-iron alloy layer, a cobalt-iron alloy layer, or a nickel-iron/cobalt-iron alloy bi-layer.

According to examples, the second ferromagnetic layer may comprise iron, cobalt, nickel, or alloys of these materials, including a cobalt-iron alloy layer, a nickel-iron alloy layer, or a nickel-iron/cobalt-iron alloy bi-layer.

According to an embodiment, the magnetic stack may comprise a synthetic anti-ferromagnetic (SAF) structure.

The SAF structure is in particular used as the reference layer.

The magneto-resistive stack and the film carrying the spin wave may be separated by a separation layer, the separation layer comprising an insulating layer.

According to an embodiment, the magneto-resistive element may comprise a magnetic material exhibiting anisotropic magnetoresistance (AMR).

According to the AMR effect, the resistivity of the magnetic material depends on the angle between the magnetization of the magnetic material and the direction of an electrical current applied to it.

According to examples, the material exhibiting anisotropic magnetoresistance may be a ferromagnetic metal or an alloy of ferromagnetic metals, such as iron, cobalt, nickel, etc., and alloys thereof, for example a nickel-iron alloy or an iron-vanadium alloy.

According to an embodiment, the magneto-resistive element may comprise a magnetic material or a multilayer material exhibiting a spin-to-charge conversion mechanism.

Spin-to-charge conversion mechanisms involve physical processes, in particular spin-orbit coupling, allowing the conversion of a spin current into an electrical charge current.

Examples include the inverse Spin-Hall effect arising in heavy metals, the Rashba-Edelstein effect arising at low-symmetry interfaces between different materials, or other spin-to-charge conversion effects related to symmetry breaking, in particular spin-momentum locking and surface states of topological insulators.

According to an embodiment, at least the magnetic film and the magneto-resistive element may form an integrated device.

Alternatively, the magnetic film and the magneto-resistive element may be mechanically independent, and be brought in immediate proximity to each other for the spin wave detection.

According to an embodiment, the device may comprise the excitation means configured to excite the spin wave in the magnetic film.

According to an example, the excitation means may comprise an excitation antenna arranged on the magnetic film.

The excitation antenna is configured to excite a spin wave by applying an oscillating current signal to the magnetic film.

The oscillating current signal is, for example, a microwave current signal, and the detected electrical signal is a microwave electrical signal.

Alternatively, other current signal forms may be applied, such as pulse or transient signals, as well, in the nonlinear regime, strong current amplitudes for which the spin-wave frequency might be different from the excitation frequency.

According to other examples, the excitation means may comprise a spin-transfer nano-oscillator, a magneto-elastic element, a magneto-electric cell, or any other spin-wave excitation means.

According to an embodiment, the measurement means may comprise an electrode connected to the magneto-resistive element.

According to examples, the magnetic film may be a nickel-iron alloy layer, a cobalt-iron alloy layer, an yttrium-iron-garnet layer, or a multilayer comprising these elements, or other ferromagnetic or ferrimagnetic materials.

According to another aspect of the same invention, it is proposed a method for the detection of spin waves, comprising:

- excitation of a spin wave in a magnetic film,
- magnetic coupling of the magnetic film to a magneto-resistive element, wherein the magneto-resistive element is configured to exhibit a magneto-resistive effect in response to a magnetization state of the magnetic film, the magnetization state of at least a part of the magneto-resistive element varying as a function of the guided spin wave,

the method further comprising:

- measuring an electrical signal corresponding to the magneto-resistive effect.

The method according to the present invention allows for dynamically measuring the electrical signal as a function of the spin wave. Therefore, information carried by the spin wave may also be dynamically detected.

According to an embodiment, the measuring step may comprise:

- applying a current to the magneto-resistive element,
- measuring a voltage at the magneto-resistive element.

According to an embodiment, the current may be oscillating at a frequency $f_2$, the measurement step comprising measuring a voltage oscillating at a frequency $f_1$-$f_2$ and/or a voltage oscillating at a frequency $f_1$+$f_2$, wherein the spin wave has a frequency $f_1$.

## Description of the figures and embodiments

Other advantages and characteristics will become apparent on examination of the detailed description of an embodiment which is in no way limitative, and the attached figures, where:

- FIGURE 1 is a simplified diagrammatic representation of an embodiment of a spin-wave detection device according to the present invention;

- FIGURE 2 shows a diagrammatic representation of an embodiment of a device for the detection of spin waves according to the present invention;

- FIGURE 3 shows an example of a magnetic stack implemented in a device according to the invention;

- FIGURE 4 shows a diagrammatic representation of a non-limitative example of a spin-wave detection method according to the present invention; and

- FIGURE 5 illustrates measurement results obtained with a device and a method according to the present invention.

It is well understood that the embodiments that will be described below are in no way limitative. In particular, it is possible to imagine variants of the invention comprising only a selection of the characteristics described hereinafter, in isolation from the other characteristics described, if this selection of characteristics is sufficient to confer a technical advantage or to differentiate the invention with respect to the state of the prior art. Such a selection comprises at least one, preferably functional, characteristic without structural details, or with only a part of the structural details if this part alone is sufficient to confer a technical advantage or to differentiate the invention with respect to the prior art.

In the Figures, elements common to several Figures may keep the same reference.

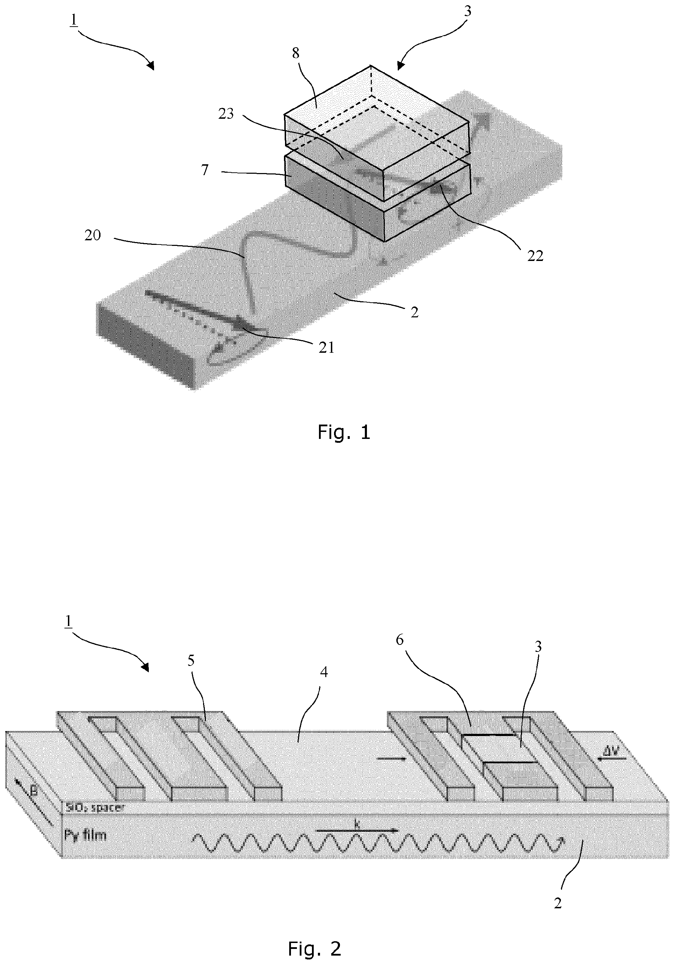

Embodiments of a device for the detection of spin waves according to the present invention, using a giant or tunnel magneto-resistive (GMRorTMR) effect, will be described in the following with respect to Figures 1 to 5.

Figure 1 is a simplified representation of an embodiment of a device for the detection of spin waves according to the present invention, illustrating the principle of measurement of spin waves using the GMR or TMR effect.

Figure 2 is a simplified diagrammatic representation of an embodiment of a device for the detection of spin waves according to the present invention.

The device 1, as represented in Figure 2, comprises a magnetic film 2 and a magnetic element 3 of at least two magnetic layers placed on the magnetic film 2. Between the magnetic film 2 and the magnetic element 3, or magnetic stack, is disposed a separation layer 4.

The magnetic film 2 allows for an efficient propagation of spin waves and acts as a waveguide. The magnetic film is preferably a nickel-iron (NiFe) alloy, or permalloy, film. Other suitable material choices include yttrium-iron-garnet (YIG) or cobalt-iron-boron (CoFeB), or other materials with low magnetic damping, or a multilayer comprising these elements.

The magnetic film 2 has a thickness ranging between several nm and several $\mu$m.

The oscillating arrow k represents a propagating spin wave in the magnetic film 2.

The equilibrium magnetization M of the magnetic film is oriented in-plane perpendicular to the propagation direction of the spin wave, and parallel to an external magnetic field B, necessary to excite a spin wave.

Of course, the device according to the invention may also be implemented such as to cover other directions of the equilibrium magnetization M, for example, with M being parallel to the waveguide or out of plane. In all cases, the spin wave must produce a change of the angle between the respective magnetizations of the reference layer and the free layer for the detection to be efficient.

The device 1 also comprises two sets of electrical conductors 5, 6. The sets of electrical conductors 5, 6 are placed on a substrate (not shown) in a distance from each other. The first set of conductors 5 is called excitation transducer, or antenna. The second set of conductors 6 form an electrode for contacting the magneto-resistive stack acting as a measurement transducer.

The distance between the sets of conductors 5, 6 is, for example, in the order of some tens of $\mu$m, but it could also be reduced down to tens or hundreds of nm. This distance should not exceed a few times the characteristic spin-wave attenuation length for the magnetic film considered.

The measurement electrode 6 is connected to the magnetic stack 3. As illustrated in the non-limitative example of Figure 2, the magnetic stack 3 forms a part of the middle strand of the measurement electrode 6.

Of course, other configurations of the sets of conductors 5, 6 with respect to the magnetic stack 3 are possible.

The sets of conductors 5, 6 may be electrically disconnected. They may also have a common ground.

Preferably, the sets of conductors 5, 6 are of gold or another low-resistivity metal such as copper, silver, or aluminium.

The separation layer 4 is an insulating layer. The separation layer 4 controls the dipolar coupling between the magneto-resistive stack 3 and the magnetic film 2 in which spin wave propagates. It also allows for avoiding electrical contacts between the conductors 5, 6 and the magnetic film 2. The separation layer 4 also serves as a protective layer.

Preferably, the separation layer 4 is of silicon dioxide (SiOz). The separation layer 4 may also be of silicon nitride, or other dielectric materials.

The separation layer 4 may be a solid, porous layer. It may also be composed of a set of pillars.

As illustrated in Figure 2, the magnetic film 2 is placed below the antenna/transducer plane. The magnetic film 2, the separation layer 4, the magnetic stack 3, and the transducers 5, 6 form an integrated device. The order of these different layers can also be reversed.

Alternatively, the magneto-resistive element may also be placed on one of the sides of the magnetic film waveguide guiding the spin wave.

According to an embodiment, the magnetic film 2 may be mechanically independent from the other components of the device (magnetic stack 3, antennas 5, 6, and separation layer 4). In operation, the magnetic film 2 may then simply be positioned on the separation layer 4 such as to cover the antennas 5, 6 and the magnetic element 3.

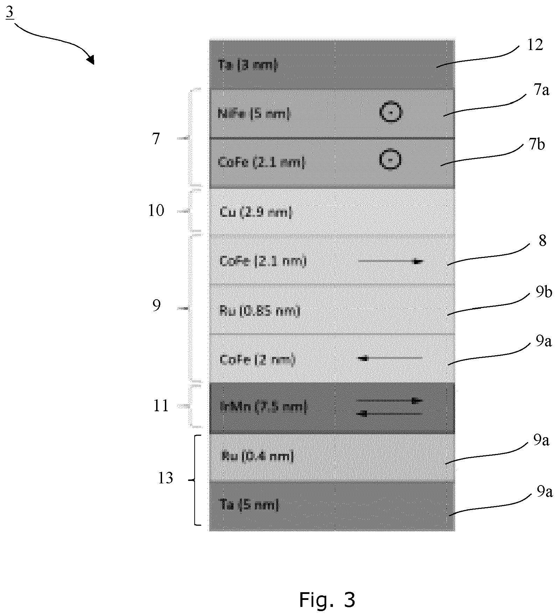

Figure 3 illustrates an example of a magneto-resistive element implemented in the invention. The illustrated magneto-resistive element is a magnetic stack 3 displaying a giant magneto-resistive effect (GMR). Such stacks are described, for example, in [5].

In Figure 3, the layer intended to be closest to the magnetic film 3 of Figure 1 is the topmost layer.

In Figure 3, the arrows indicate the magnetization direction of the different ferromagnetic layers in the absence of an external magnetic field and in the absence of spin waves in a nearby magnetic film.

The magnetic stack 3 comprises a first ferromagnetic layer 7 and a second ferromagnetic layer 8.

The first ferromagnetic layer 7 is sensitive to the dipolar field induced by a propagating spin wave, i.e., its magnetization direction may be modified by the spin wave. The first ferromagnetic layer is thus also called free layer 7, or soft layer.

The second ferromagnetic layer 8 is less sensitive to the dipolar field induced by a propagating spin wave than the first ferromagnetic layer 7, i.e., its magnetization direction is not or not strongly altered by the spin wave and thus sets a reference magnetization direction. The second ferromagnetic layer is thus also called reference layer 8, or hard layer.

Between the free layer 7 and the reference layer 8 is deposited a non-magnetic spacer layer 10. As illustrated in Figure 3, the spacer layer 10 may be of copper for a magneto-resistive stack exhibiting the giant magnetoresistance effect (GMR). The spacer layer 10 may be a an insulating layer, such as magnesium oxide (MgO), aluminium oxide ($Al_2O_3$) or magnesium aluminium oxide (MAO) with a thickness of, for example, of 1-2 nm for a stack exhibiting the tunnel magnetoresistance (TMR) effect.

The thickness of the spacer layer 10 is chosen such that the reference layer 8 and the free layer 7 are magnetically decoupled and such as to obtain a strong GMR effect within the magnetic stack 3.

The free layer 7 may comprise one or more layers. The free layer 7 may comprise iron (Fe), cobalt (Co), or nickel (Ni), or alloys of them, including a nickel-iron (NiFe) alloy, or permalloy, layer, a cobalt-iron (CoFe) alloy layer, or a nickel-iron/cobalt-iron alloy bi-layer.

In the embodiment illustrated in Figure 3, the free layer 7 comprises a NiFe layer 7a and a CoFe layer 7b.

The reference layer 8 may comprise one or more layers. The reference layer may comprise Fe, Co, Ni, or alloys of them, including a cobalt-iron alloy layer, a nickel-iron alloy layer, or a nickel-iron/cobalt-iron alloy bi-layer.

In the embodiment illustrated in Figure 3, the reference layer 8 is made of CoFe.

The reference layer 8 may be integrated into a so-called synthetic anti-ferromagnetic (SAF) structure 9. In the example illustrated in Figure 3, the SAF structure 9 comprises, in addition to the reference layer 8, a second magnetic layer 9a the magnetization of which is opposite to that of the reference layer 8, and a non-magnetic layer 9b providing the required antiferromagnetic coupling between layers 8 and 9a. In the example, the second magnetic layer 9a is of CoFe, and the non-magnetic layer 9b is of Ruthenium (Ru).

The SAF structure 9 enhances the stability of the reference layer with respect to an external magnetic field.

The second magnetic layer 9a is anti-ferromagnetically coupled to the reference layer.

The non-magnetic layer 9b is a spacer layer providing antiferromagnetic magnetic coupling.

Thanks to the combination of the layers 8, 9b, 9a of the SAF structure, the hardness of the reference layer 8 is increased, i.e., the stability of the magnetization with respect to the external magnetic field.

The SAF structure 9 is coupled to an anti-ferromagnetic layer 11. This layer 11 may be of an iridium manganese alloy (IrMn). The anti-ferromagnetic layer 11 sets a preferential magnetization direction (for example, left and not right in the plane of the figure). In order to have maximum detection sensitivity, the preferential magnetization direction is set orthogonal to that of the free layer 7. The SAF structure 9 and the anti-ferromagnetic layer 11 may be considered as a composite reference layer.

As illustrated in Figure 3, the magnetic stack 3 may further comprise a top layer 12 deposited on top of the free layer 7. The top layer 12 may be of tantalum (Ta). The top layer 12 allows for preventing oxidation of the magnetic stack 3.

The magnetic stack 3 may also comprise a bottom layer 13. In the example of Figure 3, the bottom layer 13 is a bi-layer of Ru and Ta. The bottom layer 13 increases adhesion of the magnetic stack 3 to the substrate.

The thickness of each of the single layers of the magnetic stack varies between < 1 nm and ≈ 10 nm for a magnetic stack exhibiting the GMR effect. In Figure 3, some examples thicknesses are indicated.

For a magneto-resistive stack exhibiting the TMR effect, the spacer layer consists of a thin (few nm) insulating layer. The free layer and the reference layers can have similar compositions and possibly larger thicknesses (up to 500 nm). A typical composition for the free layer and the reference layer includes cobalt-iron-boron alloys.

The width of the magnetic stack 3 with respect to the propagation direction of a spin wave in the magnetic film is in the order of a quarter of the wavelength of the spin wave.

The wavelength of the spin-wave is, for example, in the order of 10 nm-10 μm.

With reference to Figure 1, thanks to the GMR/TMR effect, the resistance of the magnetic stack 3 varies according to the relative orientations of the magnetizations between the magnetic layers of the stack 3. In Figure 1, the magnetic stack 3 is represented by free layer 7 and reference layer 8.

The propagation of a spin wave 20 in the magnetic film 2 corresponds to an excitation of the magnetization of the film 2. This excitation is represented by a processing arrow 21 for the magnetization of the film 2.

The spin wave generates an inhomogeneous oscillating dipole field both in the magnetic film 2 (demagnetizing field) and outside of it (stray field). The latter couples directly to the magnetization of the free layer 7. This coupling is referred to as dipolar coupling.

The magnetization of the free layer 7 is "following" the varying magnetization of the magnetic film 2 such that the magnetization (represented by processing arrow 22) of the free layer 7 will be precessing. The magnetization direction (represented by arrow 23) of the reference layer 8 is not or not strongly altered by the spin wave and thus sets a reference magnetization direction. Thanks to the magneto-resistive effect, the resistance of the magnetic stack 3 is oscillating as a result of the precession of the magnetization of the free layer 7. The spin wave may then be detected by measuring the resistance of the magneto-resistive stack 3.

The thickness of the separation layer between the magnetic film 2 and the free layer 7 is used to control the dipolar coupling between these two layers, which decreases as function of their spacing. This coupling should be tuned to an intermediate value allowing the free layer to be excited efficiently, while spin-wave propagation in the magnetic film is still happening.

Depending on the magnetic parameters (thickness and saturation magnetization of the magnetic film 2 and the free layer 7, external magnetic field, spin-wave wavelength), the frequency of the spin wave (and therefore of the generated dipole field) may match or not the ferromagnetic resonance frequency of the free layer, which will influence the magnitude of the magnetization precession generated in the free layer.

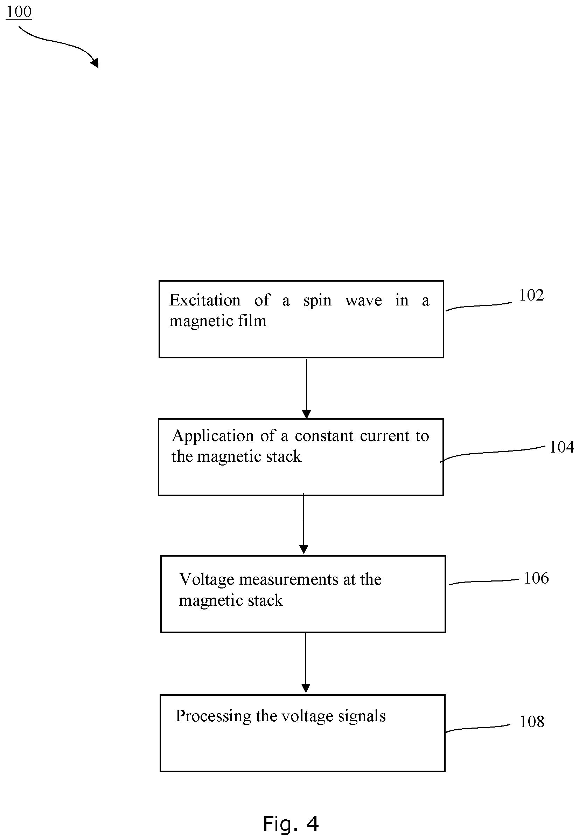

Figure 4 is a diagrammatic representation of a non-limitative example of a spin-wave detection method according to the present invention.

The device according to the invention, for example according to the embodiment described in relation with Figures 1 to 3, may be implemented in the method according to the invention.

The method is described for the case the GMR effect is exploited. The method is similar when using the TMR effect, the anisotropic magneto-resistive effect (AMR) effect or other spin-to-charge conversion mechanisms.

The method 100, according to the embodiment represented in Figure 4, comprises a step 102 of exciting a spin wave in the magnetic film 2. For this, a time-varying current $I_{1,AC}$ is injected into the excitation transducer 5. The current is preferably an oscillating microwave current signal at frequency $f_1$, in which case the spin wave also has a frequency $f_1$. The device 1 is magnetized by the application of a constant magnetic field $B_{ext}$.

Of course, other implementations involving pulse or transient spin-wave signals are possible, as well as implementations in the non-linear regime of strong current amplitudes for which the spin-wave frequency might be different from the excitation frequency.

According to the above example, the applied current signal induces an oscillating magnetic field around the excitation antenna 5. The oscillating magnetic field excites the magnetization of the magnetic film 3, which leads to the propagation of a spin wave through the magnetic film 3. The magnetic film 3 acts as a waveguide for the spin wave.

In a step 104, a constant current $I_{DC}$ is applied to the measurement transducer 5 in order to be able to measure a voltage from the change of resistance of the magnetic element.

Alternatively, a current oscillating at a frequency $f_2$ may be applied to the measurement transducer.

In a measurement step 106, a voltage $V_2$ is measured at the measurement transducer 5. The measured voltage $V_2$ at the measurement transducer 5 can be written as follows:

$$V_2 = I_{DC}\Delta R = I_{DC}\Delta R_{MR} \cos\langle\theta\rangle (t) \qquad (1)$$

where $\Delta R$ is the variation of the resistance of the magnetic stack 3 due to the MR effect, $\Delta R_{MR}$ is the maximum MR effect amplitude (for example, in the order of 5-10 % of the total resistance of a GMR stack or in the order of 50-200% of the total resistance of a TMR stack), and $\theta$ is the spatial average angle formed between the magnetizations of the free layer and the reference layer within the magnetic stack 3. The angle $\theta$ is supposed to be $\pi/2$ in the absence of a spin wave. The dipolar coupling to the spin-wave leads to a time variation of this angle (oscillatory, pulse or other transient time variation), which leads to a time variation of the transducer voltage $V_2$.

In case of application of an oscillating current with frequency $f_2$, a voltage may be detected at the sum $f_1+f_2$ or the difference $f_1-f_2$, $f_1$ being the spin-wave frequency.

In a processing step 108 of the method 100, an oscillating signal is obtained from a plurality of voltage measurements at opposite DC current values.

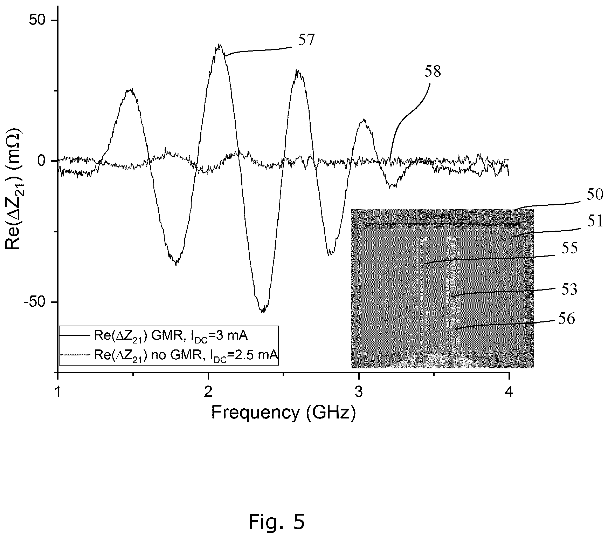

Figure 5 illustrates measurement results obtained with a device and a method according to the present invention.

The photograph insert 50 shows the excitation antenna 55 and the measurement electrode 56 including the magneto-resistive element 53. The separation layer consists of a silicon-oxide film deposited on top of the transducers 55, 56. For the measurements, a magnetic film (indicated as a transparent rectangle 51) is placed by hand on this arrangement, which results in an additional air gap separation.

In Figure 5, a signal obtained with a device according to the invention, i.e., corresponding to a GMR signal induced by a spin wave, is compared to a signal measured in similar conditions but without the magnetic stack, i.e., with a pair of inductive antenna transducers of similar size.

In Figure 5, the real parts of $Z_{21}$ are plotted versus the AC frequency of the injected oscillating current of an amplitude of about 0.4 mA, under an applied magnetic field of 30.1 mT. A DC current is applied on the measurement transducer.

The mutual impedance of the magnetic stack can be expressed as

$$Z_{21} = V_2/I_{1,AC}. \qquad (2)$$

This value corresponds to the impedance measured at the measurement transducer 5 due to the oscillating current injected in the excitation transducer 4.

It can be seen from equations (1) and (2) the variation of impedance in the magneto-resistive element is correlated to the magnetization oscillation $\theta(t)$ caused by the spin wave.

As it can be observed from Figure 5, for the case of the presence of a magnetic stack in the measurement antenna, an oscillatory signal 57 for the real part of $Z_{21}$ appears, which is attributed to propagating spin waves. For the case of the pair of antennas without a GMR stack, the signal 58 is completely flat around zero.

These measurement results are a good indication of the presence of a magneto-resistive signal produced by the magnetic stack through the GMR effect during the propagation of the spin wave.

Of course, the invention is not limited to the examples detailed above.

List of References:

[1] Castéra, J. Appl. Phys. 55, 2506 (1984)

[2] Vlaminck & Bailleul, Science 322, 410 (2008)

[3] Breitkreuz et al., IEEE Magnetics Letters 8, 3100804 (2017)

[4] Talmelli et al., Phys. Rev. Applied 10, 044060 (2018)

[5] Torrejon et al., Phys. Rev. Applied 13, 034031 (2020)

## Claims

1. A device (1) for the detection of spin waves, comprising

    - a magnetic film (2) adapted to guide a spin wave excited by an excitation means (5),
    - a magneto-resistive element (3),
    wherein the magneto-resistive element (3) is coupled to the magnetic film (2) by magnetic coupling,
    wherein the magneto-resistive element (3) is configured to exhibit a magneto-resistive effect in response to a magnetization state of the magnetic film (2), the magnetization state of at least a part of the magneto-resistive element (3) varying as a function of the guided spin wave,
    the device (1) further comprising:

        - measurement means (6) configured to detect an electrical signal corresponding to the magneto-resistive effect.

2. Device (1) according to claim 1, wherein the magnetic coupling is one of dipolar coupling, direct magnetic exchange coupling, and indirect magnetic exchange coupling.

3. Device (1) according to claim 1 or 2, wherein the magneto-resistive element (3) comprises a magneto-resistive stack comprising a first ferromagnetic layer (7), a second ferromagnetic layer (8), and a non-magnetic spacer layer (10) between the first and second ferromagnetic layers (7, 8), the magneto-resistive stack (3) being configured to exhibit a giant magneto-resistance effect or a tunnel magneto-resistive effect.

4. Device (1) according to claim 3, wherein the magneto-resistive stack (3) and the magnetic film (2) are separated by a separation layer (4), the separation layer (4) comprising an insulating layer.

5. Device (1) according to claim 1 or 2, wherein the magneto-resistive element (3) comprises a magnetic material exhibiting anisotropic magnetoresistance.

6. Device (1) according to claim 1 or 2, wherein the magneto-resistive element (3) comprises a magnetic material or a multilayer material exhibiting a spin-to-charge conversion mechanism.

7. Device (1) according to any one of the preceding claims, wherein at least the magnetic film (2) and the magneto-resistive element (3) form an integrated device.

8. Device (1) according to any one of claims 1 to 6, wherein the magnetic film (2) and the magneto-resistive element (3) are mechanically independent.

9. Device (1) according to any one of the preceding claims, further comprising the excitation means (5) configured to excite the spin wave in the magnetic film (2).

10. Device (1) according to claim 9, wherein the excitation means comprise an excitation antenna (5) arranged on the magnetic film.

11. Device (1) according to claim 10, wherein the excitation antenna is configured to excite a spin wave by applying an oscillating current signal to the magnetic film.

12. Device according to claim 11, wherein the oscillating current signal is a microwave current signal, and the detected electrical signal is a microwave electrical signal.

13. Device (1) according to any one of the preceding claims, wherein the measurement means comprise an electrode (6) connected to the magneto-resistive element (3).

14. Method (100) for the detection of spin waves, comprising:

   - excitation (102) of a spin wave in a magnetic film (2),
   - magnetic coupling of the magnetic film (2) to a magneto-resistive element (3),
   wherein the magneto-resistive element (3) is configured to exhibit a magneto-resistive effect in response to a magnetization state of the magnetic film (2), the magnetization state of at least a part of the magneto-resistive element (3) varying as a function of the guided spin wave,
   the method (100) further comprising:

      - measuring (106) an electrical signal corresponding to the magneto-resistive effect.

15. Method (100) according to claim 15, wherein the measuring step (106) comprises:

      - applying a current to the magneto-resistive element (3),
      - measuring a voltage at the magneto-resistive element (3).

16. Method (100) according to claim 16, wherein the current is oscillating at a frequency $f_2$, the measurement step comprising measuring a voltage oscillating at a frequency $f_1-f_2$ and/or a voltage oscillating at a frequency $f_1+f_2$, wherein the spin wave has a frequency $f_1$.

Fig. 1

Fig. 2

Fig. 3

100

```
┌─────────────────────────────────┐
│ Excitation  of  a  spin  wave  in  a │──── 102
│ magnetic film                   │
└─────────────────────────────────┘
              │
              ▼
┌─────────────────────────────────┐
│ Application of a constant current to │──── 104
│ the magnetic stack              │
└─────────────────────────────────┘
              │
              ▼
┌─────────────────────────────────┐
│ Voltage measurements at the     │──── 106
│ magnetic stack                  │
└─────────────────────────────────┘
              │
              ▼
┌─────────────────────────────────┐
│ Processing the voltage signals  │──── 108
│                                 │
└─────────────────────────────────┘
```

Fig. 4

Fig. 5

| Europäisches Patentamt European Patent Office Office européen des brevets | **EUROPEAN SEARCH REPORT** | **Application Number** EP 24 17 7668 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/346149 A1 (CIUBOTARU FLORIN [BE] ET AL) 30 November 2017 (2017-11-30) * paragraphs [0051] - [0103]; figures 1, 2 * | 1-7,9-16 | INV. G01R33/09 G01R33/12 H01F10/00 |
| X | US 2010/075599 A1 (XI HAIWEN [US] ET AL) 25 March 2010 (2010-03-25) * paragraphs [0017] - [0031]; figures 1-2 * | 1,8,14 | |
| X | WO 2022/179618 A1 (HUAWEI TECH CO LTD [CN]) 1 September 2022 (2022-09-01) * figures 5A-C * | 1,14 | |
| X | US 2015/085569 A1 (NOZAKI TAKAYUKI [JP] ET AL) 26 March 2015 (2015-03-26) * paragraphs [0142], [0158] - [0160]; figure 22 * | 1,14 | |
| X | WO 2017/111895 A1 (INTEL CORP [US]) 29 June 2017 (2017-06-29) * paragraphs [0071] - [0081]; figures 4-5B * | 1,14 | TECHNICAL FIELDS SEARCHED (IPC) G01R H01F |

The present search report has been drawn up for all claims

| Place of search | Date of completion of the search | Examiner |
|---|---|---|
| Munich | 5 November 2024 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 653 901 A1**

## ANNEX TO THE EUROPEAN SEARCH REPORT
## ON EUROPEAN PATENT APPLICATION NO.

EP 24 17 7668

05-11-2024

| Patent document cited in search report | | Publication date | Patent family member(s) | | Publication date |
|---|---|---|---|---|---|
| US 2017346149 | A1 | 30-11-2017 | EP | 3249705 A1 | 29-11-2017 |
| | | | US | 2017346149 A1 | 30-11-2017 |
| US 2010075599 | A1 | 25-03-2010 | NONE | | |
| WO 2022179618 | A1 | 01-09-2022 | CN | 114975767 A | 30-08-2022 |
| | | | WO | 2022179618 A1 | 01-09-2022 |
| US 2015085569 | A1 | 26-03-2015 | JP | 5673951 B2 | 18-02-2015 |
| | | | JP | 2013045840 A | 04-03-2013 |
| | | | US | 2015085569 A1 | 26-03-2015 |
| | | | WO | 2013027479 A1 | 28-02-2013 |
| WO 2017111895 | A1 | 29-06-2017 | NONE | | |

EPO FORM P0459

For more details about this annex : see Official Journal of the European Patent Office, No. 12/82